# EUROPÄISCHE PATENTSCHRIFT

(11) **EP 1 556 904 B1**
(45) Veröffentlichungstag und Bekanntmachung des Hinweises auf die Patenterteilung: **05.12.2018**
(21) Anmeldenummer: 03776808.2
(22) Anmeldetag: 21.10.2003
(51) Int. Cl.: H01L 33/50, H01L 33/38

(54) **VERFAHREN ZUM HERSTELLEN EINER LEUCHTDIODEN-LICHTQUELLE MIT LUMINESZENZ-KONVERSIONSELEMENT**
METHOD FOR PRODUCING A LIGHT SOURCE PROVIDED WITH ELECTROLUMINESCENT DIODES AND COMPRISING A LUMINESCENCE CONVERSION ELEMENT
PROCEDE POUR PRODUIRE UNE SOURCE LUMINEUSE A DIODES ELECTROLUMINESCENTES COMPRENANT UN ELEMENT DE CONVERSION DE LUMINESCENCE

(30) Priorität: 30.10.2002 DE 10250633; 10.12.2002 DE 10257664
(43) Veröffentlichungstag der Anmeldung: 27.07.2005
(73) Patentinhaber: OSRAM Opto Semiconductors GmbH, 93055 Regensburg (DE)
(72) Erfinder: BRAUNE, Bert, 93173 Wenzenbach (DE); BRUNNER, Herbert, 93161 Sinzing (DE)
(74) Vertreter: Epping - Hermann - Fischer
(86) Internationale Anmeldenummer: PCT/DE2003/003493
(87) Internationale Veröffentlichungsnummer: WO 2004/040661

(56) Entgegenhaltungen:
- EP-A- 1 111 689
- EP-A- 1 221 724
- JP-A- 2002 064 112
- JP-A- 2002 261 325
- US-A1- 2001 016 400
- US-A1- 2002 024 053
- US-B1- 6 350 668
- US-B1- 6 495 862
- PATENT ABSTRACTS OF JAPAN Bd. 1998, Nr. 05, 30. April 1998 (1998-04-30) -& JP 10 012916 A (HITACHI CABLE LTD), 16. Januar 1998 (1998-01-16)
- PATENT ABSTRACTS OF JAPAN Bd. 2000, Nr. 23, 10. Februar 2001 (2001-02-10) -& JP 2001 177158 A (MATSUSHITA ELECTRONICS INDUSTRY CORP), 29. Juni 2001 (2001-06-29)
- PATENT ABSTRACTS OF JAPAN Bd. 0111, Nr. 71 (E-512), 2. Juni 1987 (1987-06-02) -& JP 62 004351 A (TOSHIBA CORP), 10. Januar 1987 (1987-01-10)

## Beschreibung

Die Erfindung bezieht sich auf ein Verfahren zum Herstellen einer Leuchtdioden-Lichtquelle, bei der zumindest ein Teil einer von einem Chip ausgesandten Primärstrahlung wellenlängenkonvertiert wird. Ein Lumineszenz-Konversionselement ist hierbei in Form einer dünnen Schicht direkt auf die Chipoberfläche aufgebracht.

Ein Bauelement mit Lumineszenz-Konversionselement ist beispielsweise aus der Offenlegungsschrift WO 97/50132 A1 bekannt. Es umfasst einen Halbleiterchip, welcher im Betrieb eine Primärstrahlung aussendet, und ein Lumineszenz-Konversionselement, durch das ein Teil der Primärstrahlung in ein Licht von anderer Wellenlänge konvertiert wird. Die resultierende optisch wahrnehmbare Strahlung der Leuchtdioden-Lichtquelle ergibt sich durch eine Überlagerung der beiden Strahlungen, so dass sich dadurch insbesondere auch weißes Licht abstrahlende Lichtquellen erzeugen lassen.

Für gewöhnlich weist das Lumineszenz-Konversionselement einen Leuchtstoff auf, welcher in einer Matrixsubstanz eingebettet ist. Als Leuchtstoff eignen sich beispielsweise anorganische Leuchtstoffe, wie mit seltenen Erden (insbesondere Ce) dotierte Granate, oder organische Leuchtstoffe, wie Perylen-Leuchtstoffe. Weitere geeignete Leuchtstoffe sind beispielsweise in der WO 98/12757 A1 aufgeführt.

Um eine besonders gute Durchmischung der Strahlungen und somit eine farblich weitgehend homogene resultierende Strahlung zu erhalten, ist es zweckmäßig, den Leuchtstoff direkt und gleichmäßig auf der Chipoberfläche aufzubringen, so dass sich möglichst kleine Weglängenunterschiede der Primärstrahlung durch das Lumineszenz-Konversionselement ergeben. Es ist z. B. möglich, das Lumineszenz-Konversionsmaterial in Form einer dünnen homogenen Schicht von konstanter Dicke auf die Leuchtdioden-Chipoberfläche aufzubringen, noch bevor der Chip auf ein Leadframe montiert und elektrisch kontaktiert wird. Das Aufbringen dünner Schichten lässt sich auf unterschiedliche Arten realisieren und eignet sich insbesondere zur gleichzeitigen Herstellung mehrerer Leuchtdioden-Lichtquellen aus Leuchtdioden-Chips, die sich zusammen mit einer Vielzahl gleichartiger Chips in einem Waferverbund befinden. Zudem werden dadurch auch Farbortschwankungen der Leuchtdioden-Lichtquellen aufgrund von Sedimentation der Konversionsstoffe weitestgehend vermieden.

Ein einfaches Aufbringen einer dünnen Schicht ist jedoch nicht ohne weiteres möglich, wenn die verwendeten Leuchtdioden-Chips vorderseitig (d.h. auf der Seite, die zur Abstrahlrichtung hin gewandt ist) elektrische Kontaktschichten aufweisen, wie das z. B. bei GaN-basierten Dioden auf SiC-Substrat in der Regel der Fall ist. Beim Beschichten von Oberflächen solcher Leuchtdioden-Chips ist darauf zu achten, dass die elektrische Kontaktierbarkeit gewährleistet bleibt.

Die Druckschrift JP 2002-261325 A betrifft ein Verfahren, bei dem LED-Chips mit einem Lumineszenzkonversionsmaterial umgeben werden, wobei das Lumineszenzkonversionsmaterial einen Leuchtstoff und ein Matrixmaterial umfasst.

Diese Aufgabe wird durch ein Verfahren nach Anspruch 1 gelöst. Die Ansprüche 2 bis 14beinhalten vorteilhafte Weiterbildungen der Erfindung.

Aus der Druckschrift JP 2002-064112 A ist ein Herstellungsverfahren gemäß dem Oberbegriff des Anspruchs 1 bekannt, bei dem elektrische Kontakte von LED-Chips verdickt werden, bevor ein Lumineszenzkonversionsmaterial aufgebracht wird.

Der vorliegenden Erfindung liegt die Aufgabe zugrunde, ein Verfahren zu entwickeln, mit dem eine einfache und kostengünstige Beschichtung von Leuchtdioden-Chips mit vorderseitigem elektrischen Kontakt ermöglicht wird.

Diese Aufgabe wird durch ein Verfahren nach Anspruch 1 gelöst. Die abhängigen Ansprüche beinhalten vorteilhafte Weiterbildungen der Erfindung.

Ein Verfahren nach Anspruch 1 ermöglicht eine gleichzeitige Herstellung mehrerer Leuchtdioden-Lichtquellen aus gleichen Leuchtdioden-Chips im Waferverbund.

Zudem ist bei diesem Verfahren eine einfache Kontrolle des Farbortes (CIE-Farbtafel) der Leuchtdioden-Lichtquelle und dadurch auch ein kontrolliertes Einstellen des Farbortes während des Herstellungsprozesses möglich.

Bei dem Verfahren wird ein Leuchtdioden-Chip bereitgestellt, der mindestens einen oberseitigen elektrischen Kontakt in Form einer elektrischen Kontaktfläche aufweist. Dieser elektrische Kontakt wird nachfolgend erhöht, indem er durch Aufbringen eines elektrisch leitenden Materials auf die elektrische Kontaktfläche verdickt wird. Die Höhe des Kontaktes ist mindestens so groß wie die letztlich vorgesehene Dicke der Lumineszenz-Konversionsschicht. Bei einem weiteren Verfahrensschritt erfolgt ein Beschichten der Chipoberfläche mit einem Lumineszenz-Konversionsmaterial.

Mit dem erfindungsgemäßen Verfahren ist es möglich, die Beschichtung von vorderseitig elektrisch kontaktierbaren Chips ohne Rücksicht auf die vorderseitigen Kontakte durchzuführen. Dadurch wird der aufwendige Vorgang einer Beschichtung mit Freilassen elektrischer Kontakte bzw. Kontaktflächen (z. B. mittels einer Maske) auf die einfache und kostengünstig zu realisierende Beschichtung einer durchgehenden Oberfläche reduziert.

Das Lumineszenz-Konversionsmaterial weist vorzugsweise ein strahlungsdurchlässiges Matrixmaterial auf, welches mit einem Leuchtstoff versetzt ist.

Das Matrix-Material kann beispielsweise SiO₂ und/oder Al₂O₃ aufweisen, wodurch eine Konsistenz (z. B. die Härte) des Lumineszenz-Konversionsmaterials erreicht werden kann, die sich auf vielfache Art problemlos und kontrolliert abdünnen lässt.

In einer besonders bevorzugten Ausführung des Verfahrens weist das strahlungsdurchlässige Matrix-Material ein Oxid und/oder ein Nitrid auf, dessen Brechungsindex zwischen 1,5 und 3,4 liegt. Durch ein Lumineszenz-Konversionsmaterial, dessen Brechungsindex sich nicht stark von dem der Leuchtdioden-Chipoberflache unterscheidet und zwischen dem Brechungsindex der Leuchtdioden-Chipoberflache und dem der Umgebung liegt, können Verluste an Strahlungsintensität aufgrund von Reflexion an Grenzflächen vermieden werden.

Mit besonderem Vorteil werden bei dem Verfahren elektrische Anschlüsse, welche mit Lumineszenz-Konversionsmaterial bedeckt sind, nachfolgend durch ein Abdünnen des Lumineszenz-Konversionsmaterials zumindest teilweise freigelegt. D.h., die elektrischen Anschlüsse müssen nicht komplett freigelegt werden, vielmehr reicht es aus, wenn lediglich eine Teilfläche eines elektrischen Anschlusses freigelegt wird. Diese einfache Maßnahme ermöglicht die Verwendung vieler verschiedener Beschichtungsverfahren, wie z. B. Aufdampfen oder Aufsputtern, bei denen vorderseitige elektrische Anschlüsse bedeckt werden.

In einer bevorzugten Ausführung des Verfahrens wird die Schicht aus Lumineszenz-Konversionsmaterial nachfolgend durch Abdünnen geebnet. Beim Beschichten kann es z. B. aufgrund der vorderseitigen erhöhten elektrischen Kontakte zu Unebenheiten in der Schicht kommen. Durch ein Abdünnen von diesen erhält man geringere Schwankungen sowie eine bessere Reproduzierbarkeit des Farbortes (CIE Farbtafel) der Leuchtdioden-Lichtquellen.

Der Farbort der Leuchtdioden-Lichtquelle lässt sich wegen des oberseitigen elektrischen Kontakts nachfolgend mit besonderem Vorteil kontrollieren. Diese Kontrolle wird erfindungsgemäß im Verlauf des Abdünnens des aufgetragenen Lumineszenz-Konversionsmaterials durchgeführt und ist möglich, sobald der oberseitige elektrische Kontakt freigelegt ist.

Die Dicke der Schicht aus Lumineszenz-Konversionsmaterial lässt sich zweckmäßig durch Dünnen einstellen.

Zudem wird durch die Kontrolle des Farbortes der Leuchtdioden-Lichtquelle die Korrelation zwischen Dicke der Lumineszenz-Konversionsschicht und dem Farbort ermittelt. Dies wird verwendet, um den Farbort gezielt durch Abdünnen des aufgetragenen Lumineszenz-Konversionsmaterials einzustellen.

Das Verfahren eignet sich erfindungsgemäß zur gleichzeitigen Herstellung mehrerer Leuchtdioden-Lichtquellen durch die Verwendung einer Vielzahl gleichartiger Leuchtdioden-Chips, welche sich noch in einem ursprünglichen Waferverbund miteinander befinden. Die jeweiligen Verfahrensschritte für die Chips des Waferverbundes erfolgen dabei zumindest im Wesentlichen gleichzeitig. Dadurch ergibt sich eine deutlich effizientere und kostengünstigere Herstellung der Leuchtdioden-Lichtquellen.

Da ein Leuchtdioden-Chip Licht nicht nur vorderseitig, sondern auch seitlich abstrahlen kann, ist es bei derartigen Chips von besonderem Vorteil, auch die Flanken der Leuchtdioden-Chips zumindest teilweise mit Lumineszenz-Konversionsmaterial zu beschichten. Bei der Beschichtung einer Vielzahl von Leuchtdioden-Chips im Waferverbund ist es hier zweckmäßig, vor dem Beschichten entlang von Trennungslinien zwischen den einzelnen Chips Gräben herzustellen, die bei dem nachfolgenden Beschichten der Chips zumindest teilweise mit Lumineszenz-Konversionsmaterial gefüllt werden.

Eine weitere Möglichkeit ist es, den gesamten Waferverbund mit der Unterseite zunächst auf einem Träger fest aufzubringen und daraufhin die Chips aus dem Waferverbund derart zu vereinzeln, dass sie nach wie vor auf dem Träger zusammengehalten werden, d.h. , dass sie nachfolgend mittels dem Träger weiter in einem Verbund gehalten werden. Auch dadurch ist gewährleistet, dass die Flanken der Leuchtdioden-Chips bei der nachfolgenden Beschichtung zumindest teilweise mit Lumineszenz-Konversionsmaterial bedeckt werden.

Den Farbort der Leuchtdioden-Lichtquelle im Verlauf des Abdünnens des Lumineszenz-Konversionsmaterials zu überprüfen, wird bei der Anwendung des erfindungsgemäßen Verfahrens zur gleichzeitigen Herstellung mehrerer Leuchtdioden-Lichtquellen aus einer Vielzahl gleicher Chips im Waferverbund genutzt. Das Bestimmen und Erfassen von Farbort und Lage der Leuchtdioden-Lichtquellen im Waferverbund ermöglicht erfindungsgemäß, die Leuchtdioden-Lichtquellen nach ihrem Farbort zu sortieren, um somit Leuchtdioden-Lichtquellen von genauerer Farbortspezifikation zu erhalten.

Das erfindungsgemäße Verfahren wird genutzt, um für die Leuchtdioden-Lichtquellen eines gesamten Waferverbundes einen bestimmten Farbort möglichst genau einzustellen. Da die Höhe von Leuchtdioden-Chips eines Waferverbundes nicht über den gesamten Wafer homogen ist und es zu Höhenschwankungen von beispielsweise 20 µm kommen kann, führt ein gleichmäßiges Abdünnen des Lumineszenz-Konversionsmaterials über den gesamten Wafer hinweg zu unterschiedlichen Dicken der Lumineszenz-Konversionsschicht. Dieses Problem wird mithilfe des erfindungsgemäßen Verfahrens gelöst, indem der Wafer in Bereiche mit Leuchtdioden-Lichtquellen von ähnlichem Farbort unterteilt wird, nachdem Farbort und Lage der Leuchtdioden-Lichtquellen des Wafers bestimmt und erfasst wurden. Das Einstellen eines bestimmten Farbortes für jeden dieser Bereiche lässt sich erreichen, indem die Lumineszenz-Konversionsschicht der einzelnen Bereiche bereichsselektiv abgedünnt wird und dabei immer wieder eine Kontrolle des Farbortes von einer der Leuchtdioden-Lichtquellen des jeweiligen Bereichs durchgeführt wird.

Weitere Vorteile und bevorzugte Ausführungsformen ergeben sich aus der nachfolgenden Beschreibung in Verbindung mit den Figuren 1a bis 2b. Es zeigen:
Figuren 1a bis 1f: Schematische Schnittansichten eines Wafers bei verschiedenen Verfahrensstadien eines Ausführungsbeispiels,
Figuren 2a und 2b: Schematische Schnittansichten eines Wafers bei verschiedenen Verfahrensstadien und
Figuren 3a und 3b: Schematische Schnittansichten eines Wafers bei verschiedenen Verfahrensstadien.

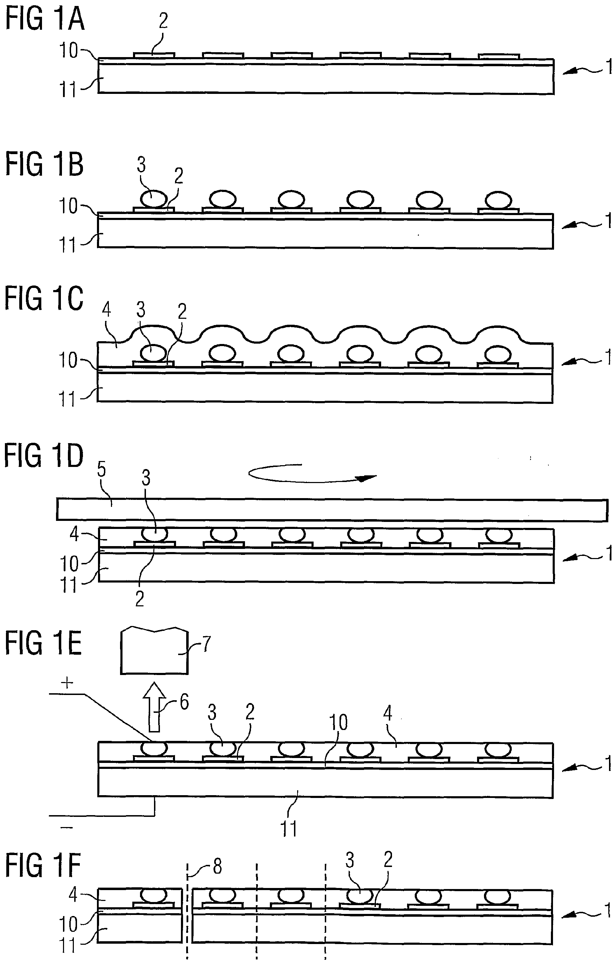

Figur 1a zeigt einen Wafer 1, umfassend ein SiC-Substrat 11 und eine InGaN-basierte epitaktische Halbleiterschichtfolge 10 mit strahlungsemittierenden aktiven Zone (nicht gezeigt). Die aktive Zone weist beispielsweise einen strahlungserzeugenden pn-Übergang oder eine strahlungserzeugende Einfach- oder Mehrfach-Quantenstruktur auf. Solche Strukturen sind dem Fachmann bekannt und werden von daher nicht näher erläutert. Eine Mehrfach-Quantenstruktur ist beispielsweise in der WO 01/39282 A2 beschrieben. Auf dem Wafer 1 sind in einem Chipraster jeweils vorderseitig elektrische Kontaktflächen 2 aufgebracht.

Ein weiterer Verfahrensschritt ist in Figur 1b dargestellt, bei dem eine Erhöhung der elektrischen Kontakte erreicht wird, indem ein elektrisch leitfähiges Material 3 auf die elektrischen Kontaktflächen 2 gebracht wird. Das elektrisch leitfähige Material 3 ist hier näherungsweise ellipsoidförmig und kann beispielsweise aus Gold bestehen. Die Tatsache, dass das elektrisch leitfähige Material 3 lediglich eine Mindesthöhe, nicht aber jeweils eine gleiche Höhe haben muss, ist ein weiterer Vorteil des Verfahrens.

Nachfolgend wird, wie in Figur 1c gezeigt, die gesamte vorderseitige Oberfläche des Waferverbundes 1 mit einem Lumineszenzkonversionsmaterial 4 beschichtet, was z. B. durch Aufdampfen, Sputtern, Spin-Coating oder andere Methoden zur Oberflächenbeschichtung geschehen kann. Das Lumineszenzkonversionsmaterial kann aus einem Ce-dotiertem Granatmaterial bestehen, insbesondere YAG:Ce. Auch bei diesem Schritt kommt es darauf an, dass die aufgebrachte Schicht aus Lumineszenzkonversionsmaterial 4 über dem gesamten Waferbereich eine gewisse Mindestdicke hat.

Eine gleichmäßige Dicke der aufgebrachten Schicht Lumineszenzkonversionsmaterial 4 ergibt sich aus dem nachfolgenden Abdünnen der gehärteten Lumineszenzkonversionsschicht, welches in Figur 1d dargestellt ist. Das Abdünnen geschieht abrasiv mittels einer Schleiffläche 5.

Sobald das elektrisch leitende Material 3 durch das Abdünnen freigeigt wird, ist eine gezielte elektrische Kontaktierung und Anlegen einer Spannung an Bereiche einzelner Chips möglich. Dies ermöglicht ein Ermitteln des Farbortes des ausgesandten Lichts 6 mittels eines Spektrometers 7, was in Figur 1e gezeigt ist. Es wird gezielt solange weiter abgedünnt, bis die Leuchtdioden-Lichtquellen z. B. alle weißes Licht aussenden.

Da der Farbort von Leuchtdiodenchips eines Wafers über den Wafer verteilt in der Regel variiert, wird der Wafer in Bereiche mit Leuchtdioden von ähnlichem Farbort eingeteilt. Nachfolgend wird das Lumineszenz-Konversionsmaterial bereichsselektiv abgedünnt und der Farbort der Leuchtdioden-Lichtquellen eines Bereiches eingestellt, indem der Farbort von nur einer Leuchtdioden-Lichtquelle eines Bereiches während des Abdünnens immer wieder kontrolliert wird. Von allen Leuchtdioden-Lichtquellen wird nachfolgend der jeweilige Farbort und die jeweilige Position auf dem Wafer ermittelt und erfasst, z. B. durch das Erstellen einer sogenannten Wafer-map.

Figur 1f schließlich zeigt das Vereinzeln der Chips aus dem Waferverbund 1 entlang von Trennungslinien 8. Dies kann z. B. mittels Sägen geschehen. Die vereinzelten Chips lassen sich nun nach ihrem Farbort sortieren.

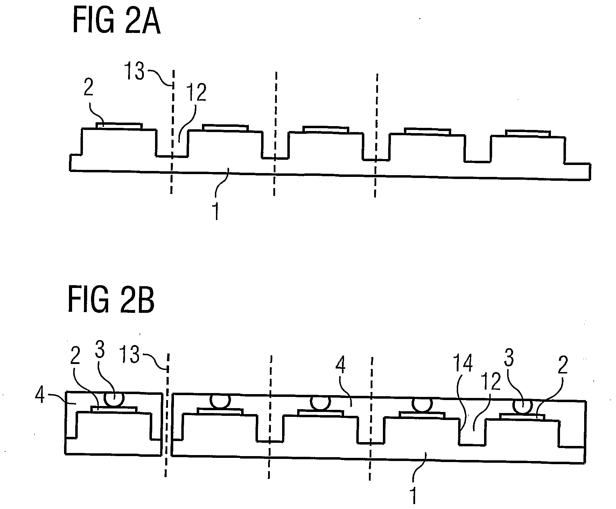

Bei dem in den Figuren 2a und 2b veranschaulichten Verfahren werden, im Unterschied zum oben erläuterten Ausführungsbeispiel gemäß den Figuren 1a bis 1f, vor dem Beschichten mit Lumineszenz-Konversionsmaterial 4 im Chipraster auf dem Wafer 1 vorderseitig entlang von Trennungslinien 13 Gräben 12 erzeugt (Figur 2a), was beispielsweise durch Sägen erfolgen kann. Im weiteren Verlauf des Verfahrens wird auf die Chipvorderseiten so viel Lumineszenz-Konversionmaterial 4 aufgetragen, dass die Schicht über den Gräben 12 mindestens über das auf die elektrischen Kontaktflächen 2 aufgetragene elektrisch leitende Material 3 reicht (Figur 2b). Die Seiten 14 der Gräben 12 werden dadurch vollständig mit dem Lumineszenz-Konversionsmaterial 4 bedeckt. Das in den Gräben 12 aufgebrachte Lumineszenz-Konversionsmaterial 4 bewirkt, dass eine über die Chipflanken ausgekoppelte Strahlung ebenfalls konvertiert wird. Wie in Figur 2b gezeigt, werden die Chips nach dem Abdünnen des Lumineszenz-Konversionsmaterials 4 entlang der Trennungslinien 13 vereinzelt.

Statt auf dem Wafer vorderseitig entlang von Trennungslinien Gräben zu erzeugen, kann der Wafer alternativ mit der Unterseite auf einen Träger aufgebracht und die Chips nachfolgend aus dem Waferverbund derart vereinzelt werden, dass sie durch den Träger zusammengehalten werden und die einzelnen Chips einen definierten Abstand voneinander aufweisen (nicht gezeigt). Das Vereinzeln kann z.B. durch Sägen erfolgen. Als Träger kann beispielsweise eine adhäsive und/oder dehnbare Folie verwendet werden. Eine dehnbare Folie kann z. B. nach dem Vereinzeln der Chips derart gedehnt werden, dass sich der Abstand der Chips voneinander gleichmäßig in einer oder in mehreren Richtung bzw. Richtungen vergrößert.

Auf den Träger kann nachfolgend Lumineszenz-Konversionsmaterial aufgebracht werden, so dass Zwischenräume zwischen benachbarten Chips teilweise oder ganz gefüllt werden. Hierdurch kann erreicht werden, dass bis auf die Rückseite alle Oberflächen der Chips komplett mit Lumineszenz-Konversionsmaterial bedeckt werden, wodurch eine besonders homogene Abstrahlcharakteristik von derart hergestellten Leuchtdioden-Lichtquellen erreicht werden kann.

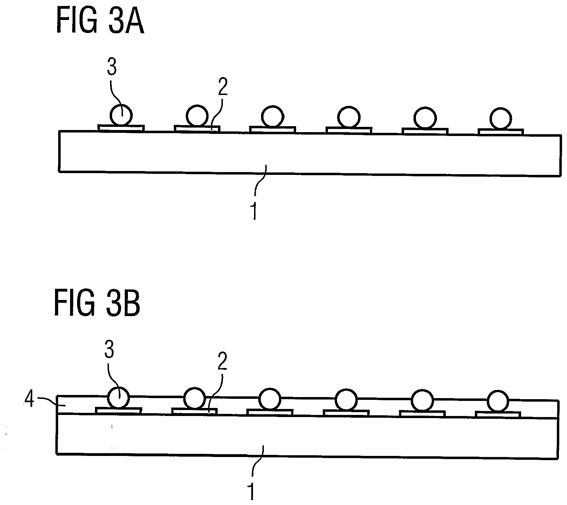

Bei dem in den Figuren 3a und 3b veranschaulichten Verfahren wird, im Unterschied zum oben erläuterten Ausführungsbeispiel gemäß den Figuren 1a bis 1f, Lumineszenz-Konversionsmaterial 4 derart aufgebracht, dass das aufgetragene elektrisch leitende Material 3 vorderseitig nicht bedeckt wird. Dies kann z. B. durch Verwendung eines Lumineszenz-Konversionsmaterials 4 von sehr geringer Viskosität geschehen, welches auf mindestens einer Stelle zwischen den elektrischen Kontakten aufgebracht wird und sich daraufhin aufgrund der geringen Viskosität gleichmäßig auf der Oberfläche verteilt. Hierbei entfällt ein Abdünnen des Lumineszenz-Konversionsmaterials, das elektrisch leitende Material 3 bleibt zumindest teilweise frei. Nach dem Aushärten des Lumineszenz-Konversionsmaterials 4 können die Leuchtdioden-Lichtquellen vereinzelt werden.

## Patentansprüche

1. Verfahren zum Herstellen einer mischfarbigen Leuchtdioden-Lichtquelle, bei der zumindest ein Teil einer von einem Chip ausgesandten Primärstrahlung mittels Lumineszenzkonversion umgewandelt wird,
mit den Schritten:
- Bereitstellen eines Chips, der einen vorderseitigen elektrischen Kontakt in Form einer elektrischen Kontaktfläche (2) aufweist,
- Verdicken des vorderseitigen elektrischen Kontaktes durch Aufbringen eines elektrisch leitenden Materials (3) auf die elektrische Kontaktfläche (2),
- Beschichten des Chips mit einem Lumineszenz-Konversionsmaterial (4),
wobei
- sich der die Primärstrahlung (6) aussendende Chip in einem Waferverbund (1) mit einer Vielzahl weiterer gleichartiger Chips befindet,
- die jeweiligen Verfahrensschritte für die Chips des gesamten Waferverbundes (1) jeweils gleichzeitig erfolgen, und
- die Chips nachfolgend vereinzelt werden,
**dadurch gekennzeichnet, dass**
- vor dem Vereinzeln der Chips folgende Verfahrensschritte durchgeführt werden:
- Bestimmen und Erfassen von Farbort und Lage der Leuchtdioden-Lichtquellen,
- Unterteilen des Wafers in Bereiche mit Leuchtdioden-Lichtquellen von ähnlichem Farbort, und
- Einstellen von jeweils einem bestimmten Farbort für die Bereiche mit Leuchtdioden-Lichtquellen von ähnlichem Farbort für den gesamten Waferverbund (1) durch ein bereichsselektives Abdünnen des Lumineszenz-Konversionsmaterials der einzelnen Bereiche, wobei während des Abdünnnes immer wieder eine Kontrolle des Farbortes von einer der Leuchtdioden-Lichtquellen des jeweiligen Bereichs durchgeführt wird.

2. Verfahren nach Anspruch 1,
bei dem das Lumineszenz-Konversionsmaterial (4) ein strahlungsdurchlässiges Matrixmaterial aufweist, welches mit einem Leuchtstoff versetzt ist.

3. Verfahren nach Anspruch 2,
bei dem das strahlungsdurchlässige Matrixmaterial SiO₂ und/oder Al₂0₃ aufweist.

4. Verfahren nach einem der vorhergehenden Ansprüche,
bei dem die Schicht aus Lumineszenzkonversionsmaterial (4) durch Abdünnen mittels einer Schleiffläche (5) geebnet wird.

## Claims

1. A method for producing a mixed-colored light-emitting diode light source in which at least part of a primary radiation emitted by a chip is converted by means of luminescence conversion,
comprising the steps of:
- providing a chip which has a front-side electrical contact in the form of an electrical contact area (2),
- thickening of the front-side electrical contact by applying an electrically conductive material (3) to the electrical contact surface (2),
- coating the chip with a luminescence conversion material (4),
wherein
- the chip emitting the primary radiation (6) is located in a wafer assembly (1) having a plurality of further similar chips,
- the respective method steps for the chips of the entire wafer assembly (1) each take place simultaneously, and
- the chips are subsequently singulated,
**characterized in that**
the following method steps are carried out before the chips are separated:
- determining and detecting the color locus and the position of the light-emitting diode light sources,
- subdividing the wafer into regions with light-emitting diode light sources of similar color location, and
- setting a respective specific color location for the regions with light-emitting diode light sources of similar color location for the entire wafer assembly (1) by a region-selective thinning of the luminescence conversion material of the individual regions, wherein during the thinning a check of the color location of one of the light sources of the respective region is repeatedly performed.

2. The method according to claim 1,
in which the luminescence conversion material (4) comprises a radiation-transmissive matrix material which is admixed with a phosphor.

3. The method according to claim 2,
in which the radiation-transmissive matrix material comprises SiO₂ and/or Al₂O₃.

4. The method according to one of the preceding claims,
in which the layer of luminescence conversion material (4) is planarized by thinning by means of a grinding surface (5).

## Revendications

1. Procédé pour produire une source lumineuse à diodes électroluminescentes de couleurs mélangées, dans lequel au moins une partie d'un rayonnement primaire émis par une puce est convertie par conversion de luminescence,
comprenant les étapes :
- fourniture d'une puce qui présente un contact électrique de face avant, sous la forme d'une surface de contact électrique (2),
- épaississement du contact électrique de face avant par application d'un matériau conducteur électrique (3) sur la surface de contact électrique (2),
- enduction de la puce avec un matériau de conversion de luminescence (4),
attendu que
- la puce qui émet le rayonnement primaire (6) se trouve dans une planche (1) avec une pluralité d'autres puces similaires,
- les différentes étapes de procédé s'effectuent respectivement en même temps pour les puces de toute la planche (1), et que
- les puces sont individualisées après,
**caractérisé en ce que**
- les étapes suivantes sont réalisées avant l'individualisation des puces :
- détermination et identification du lieu spectral et de la position des sources lumineuses à diodes électroluminescentes,
- subdivision de la planche en zones à sources lumineuses à diodes électroluminescentes de lieu spectral similaire, et
- réglage d'un lieu spectral respectif déterminé pour les zones à sources lumineuses à diodes électroluminescentes de lieu spectral similaire pour toute la tranche (1) par un amincissement par sélection de zone du matériau de conversion de luminescence des différentes zones, un contrôle du lieu spectral d'une des sources lumineuses à diodes luminescentes de la zone concernées étant régulièrement effectué pendant l'amincissement.

2. Procédé selon la revendication 1,
dans lequel le matériau de conversion de luminescence (4) présente un matériau de matrice perméable aux rayonnements, auquel matériau est ajoutée une substance luminescente.

3. Procédé selon la revendication 2,
dans lequel le matériau de matrice perméable aux rayonnements présente du SiO₂ et/ou du Al₂O₃.

4. Procédé selon l'une quelconque des revendications précédentes, dans lequel la couche en matériau de conversion de luminescence (4) est nivelée par amincissement au moyen d'une surface de meulage (5).
